Europäisches Patentamt

European Patent Office

Office européen des brevets

(11) Publication number: **0 296 586 B1**

# EUROPEAN PATENT SPECIFICATION

(45) Date of publication of patent specification: **10.06.92**    (51) Int. Cl.⁵: **G11C 11/404**, G11C 11/24, H01L 27/10

(21) Application number: **88110021.8**

(22) Date of filing: **23.06.88**

(54) Semiconductor memory device with improved cell arrangement.

(30) Priority: **25.06.87 JP 159324/87**

(43) Date of publication of application:
**28.12.88 Bulletin 88/52**

(45) Publication of the grant of the patent:
**10.06.92 Bulletin 92/24**

(84) Designated Contracting States:
**DE FR GB**

(56) References cited:
**EP-A- 0 108 390**
**EP-A- 0 186 875**
**US-A- 4 675 848**

(73) Proprietor: **NEC CORPORATION**
**7-1, Shiba 5-chome Minato-ku**
**Tokyo 108-01(JP)**

(72) Inventor: **Kawata, Kouji c/o NEC Corporation**
**33-1, Shiba 5-chome**
**Minato-ku Tokyo(JP)**

(74) Representative: **Glawe, Delfs, Moll & Partner**
**Patentanwälte**
**Postfach 26 01 62 Liebherrstrasse 20**
**W-8000 München 26(DE)**

## Description

BACKGROUND OF THE INVENTION:

The present invention relates to a semiconductor memory device fabricated on a semiconductor substrate and more particularly to a dynamic type semiconductor memory device employing one transistor-one capacitor type memory cells.

A dynamic semiconductor memory device is structured such that at least one memory cell array is provided near a central zone of a semiconductor chip and peripheral circuits such as an address buffer/decoder and a data input/output circuit are arranged in a peripheral zone of the central zone of the semiconductor chip. The dynamic type semiconductor memory device thus arranged is responsive to address signals and control signals to write or read data informations into or from the memory cell array.

In write or read operation, the peripheral circuits are enabled, so that electric charges from the peripheral circuits flow into the memory cell array area of the semiconductor chip. The information are stored in the form of electric charges in storage capacitors of the memory cells. Thus, the data information is liable to be affected by the electric charges come from the peripheral circuits. Moreover, in view of formation of the memory cell array, particularly, the uniformity of the memory cell array, for example that of insulating layer in the memory cell array is generally decreased near the peripheral portion of the memory cell array. For example, the deviation in thickness of the insulating layer from a desired value is relatively small in the central portion of the memory cell array while the deviation in thickness of the insulating layer from the desired value is relatively large in the peripheral portion of the memory cell array. Thus, there is tendency that electrical characteristics of elements in the side portions of the memory cell array cannot satisfy the required provisions.

Thus, in the worst case, data information stored in the memory cells in the peripheral or outer portion of the memory cell array is destroyed or inverted in logic levels.

SUMMARY OF THE INVENTION:

It is an object of the present invention to provide a dynamic type semiconductor memory device having an improved memory cell array whose outer region cells are free from data destruction.

The semiconductor memory device according to the present invention is specified in claim 1. It comprises at least one memory cell array having a plurality of memory cells arranged in rows and columns, and a peripheral circuit arranged outside the memory cell array for achieving a read or write operation with respect to a selected memory cell, and is featured in that each of the storage capacitors of the memory cells in the two outer columns has a larger dimension or capacitance than the storage capacitors of the memory cells in the inner columns other than the two outer columns.

According to the present invention, the storage capacitors of the memory cells in the outer columns have the increased value of capacitances and therefore they are hardly affected by electric charges or noises from the outside of the memory cell array.

BRIEF DESCRIPTION OF THE DRAWINGS:

Fig. 1 is a plan view showing a general layout of a semiconductor memory device;
Fig. 2 is a schematic block diagram of a cell array with peripheral circuits;
Fig. 3 is a schematic circuit diagram of a dynamic memory cell;
Fig. 4 is a plan view showing patterns of memory cells according to a prior art;
Fig. 5 is a plan view showing patterns of memory cells according to a first embodiment of the present invention;
Fig. 6 is a sectional view along the axis A-A$'$ of Fig. 5;
Fig. 7 is a plan view showing patterns of memory cells according to a second embodiment of the present invention; and
Fig. 8 is a drawing explaining the effect of the invention.

DETAILED DESCRIPTION OF THE INVENTION:

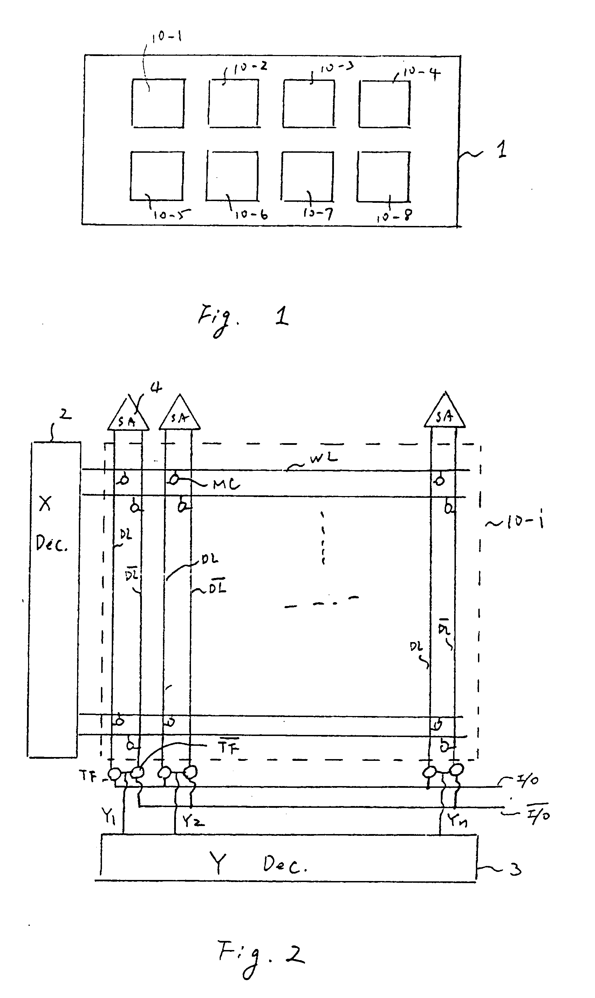

First, referring to Figs. 1 to 4, a memory device according to a prior art will be explained.

A general arrangement of memory cells in a dynamic memory device is show in Fig. 1.

A large number of memory cells are grouped into, in this case, 8 memory arrays 10-1 to 10-8 formed on a semiconductor chip 1. For example, in the case where the total memory capacity of the memory device is 256 k-bits, each of the memory array 10-1 to 10-8 includes 32 k-bits of memory cells. Although, not indicated in Fig. 1, the peripheral circuits such as row (X) decoders, column decoders are arranged outsides of the respective memory arrays. The number of the memory arrays is optional and determined according to design choice.

The general structure of each memory array 10-i and its peripheral circuits are shown in Fig. 2.

The memory array 10-i ($1 \leq i \leq 8$) includes a plurality of word lines WL arranged in rows, a plurality of pairs of bit lines DL, $\overline{DL}$ arranged in

columns and a plurality of memory cells MC coupled to the word lines WL and the bit lines in a known way. A plurality of sense amplifiers 4 are provided for the respective columns and connected to the pair of bit lines of that column. A row (X) decoder 2 is coupled to the word lines WL. A pair of bus lines I/O and $\overline{I/O}$ are coupled to the respective pairs of bit lines DL, $\overline{DL}$ via a plurality of pairs of transfer gates TF, $\overline{TF}$ which are selected by outputs $Y_0$ - $Y_n$ of a column (Y) decoder 3 in a known way.

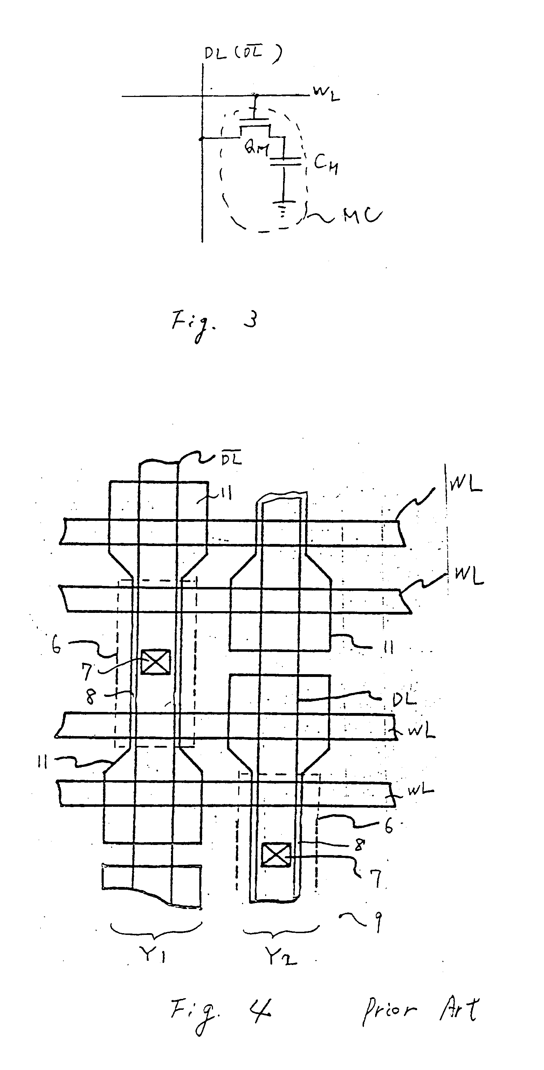

A circuit structure of the memory cells MC is shown in Fig. 3. Each of the memory cells MC includes a memory cell transistor $Q_M$ and a storage capacitor $C_M$ connected in series between the bit line DL and a fixed potential such as a ground potential.

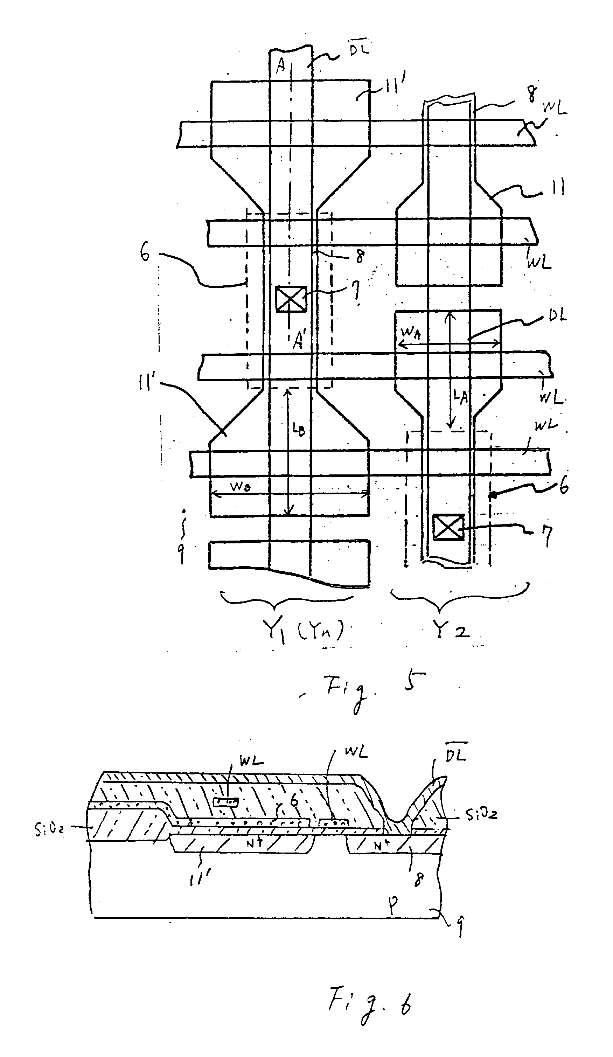

A pattern of a part of the memory array 10-i according to a prior art is shown in Fig. 4. The bit line $\overline{DL}$ of the outer, side column, e.g. that selected by the column selection output $Y_1$ (column of $Y_1$) and the bit line DL of the inner side column e.g. that selected by $Y_1$ (column of $Y_1$) are representatively shown in Fig. 4. The bit lines DL, $\overline{DL}$ are made of aluminum strips extending in column direction and the word lines are made of polycrystalline silicon extending in row direction. N-type regions 11 formed in a P-type substrate 9 serve as one electrodes of the capacitors $C_M$. N-type regions 8 are connected to the bit lines DL, $\overline{DL}$ via contact holes 7. Between the N-type regions 11 and 8, charge transfer regions are defined. A polycrystalline silicon layer 6 is covered the substrate via an insulating layer (not shown) at least above the N-type regions 11 except for the contacts and the charge transfer regions. The polycrystalline silicon layer 6 serves as the other, opposite electrodes of the cell capacitors $C_M$.

As is seen from Fig. 4, all the capacitors $C_M$ in the respective memory arrays 10-i have the same configuration and the same size. In particular, the configuration and the size of the respective N-type regions 11 are the same throughout the each memory array 10-i.

Since the peripheral circuits such as decoders, and sense amplifiers operatively discharge a relatively large amount of electric charges and some part of the discharged charges leak to the memory cell capacitor $C_M$ to reduce electric charges stored therein.

Moreover, the capacitors $C_M$ in the periphery side column have deviations in the electric characteristics due to the deviations in forming the N-type regions 11 and the insulating layer thereof and therefore such capacitors in the periphery side column have less ideal characteristics, e.g. smaller capacitance values.

Accordingly, in the conventional semiconductor memory device, the states of the memory cell capacitors $C_M$ in the outer, side columns, i.e. the columns of $Y_1$ and $Y_n$ are liable to be affected by the peripheral circuits and is less reliable.

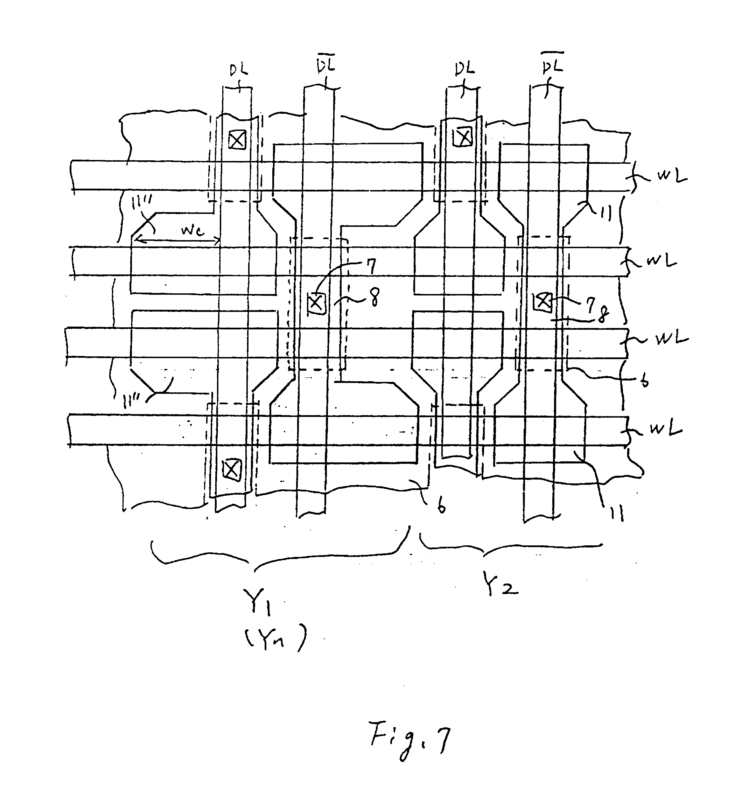

With reference to Figs. 5 and 6, a part of the memory array according to one embodiment of the present invention will be explained.

In Figs. 5 and 6, the portions corresponding to those of Fig. 4 are denoted by the same or similar reference numerals.

The present embodiment is obtained by enlarging the area of the N-type regions 11 of only the periphery side columns of $Y_1$ and $Y_n$ in Fig. 4 to form enlarged N-type regions 11' as the one electrodes of the memory cell capacitors, as illustrated in Fig. 5. While the N-type regions 11 of the columns $Y_2$ - $Y_{n-1}$ which are inner columns, have the same size as those 11 in Fig. 4.

In particular, the width $W_B$ of the N-type regions 11' is made larger than the width $W_A$ of the N-type regions 11 while the length $L_B$ of the N-type regions 11' are made equal to the length $L_A$ of the N-type regions 11. This is because the number of the memory cells arranged in the respective columns of $Y_1$ - $Y_n$ must be the same and the memory cells must be arranged in accordance with the arrangement of the word lines in the respective columns, while it is allowed to enlarge the width $W_B$ of the N-type regions 11' of the periphery side columns of $Y_1$ and $Y_2$ without disturbing the whole memory cell arrangement in the respective arrays.

Assuming that the respective area or capacitance of the capacitors $C_M$ of the side columns $Y_1$ and $Y_n$ is $C_B$ and the area or capacitance of the capacitors $C_M$ of the inner columns of $Y_2$ - $Y_{n-1}$ is $C_A$, the area ratio $C_B/C_A$ is favorably set at 1.2 to 2.

Namely, normalized soft error rate of the memory cells in the side column with respect to the ratio of $C_B/C_A$ in Fig. 8. In Fig. 8, EN indicates the error rate of the memory cells of the inner columns. As is shown in Fig. 8, the error rate is not significantly improved between 1 to 1.2 of $C_B/C_A$. But the error rate is improved from 1.2 of $C_B/C_A$ and becomes the same error rate as EN around 1.5 of $C_B/C_A$. Then, the error rate is gradually improved after 1.5 of $C_B/C_A$. In the case of $C_B/C_A$ of less than 1.2, the effect against the charges is not sufficient. While in the case of $C_B/C_A$ of more than 2, it is not practical to arrange a large number of memory cells in the respective memory arrays with high-density structure.

In particular, the above ratio $C_B/C_A$ is achieved favorably by setting the ratio of $W_B/W_A$ at 1.2 to 2 in the case of the same value of $L_A$ and $L_B$ with case.

According to the present invention, the capacitance of the memory cell capacitors $C_M$ of the side columns of $Y_1$ and $Y_n$ is made increased, and therefore electric charges stored in the capacitors in the periphery columns $Y_1$ and $Y_n$ are also increased. Therefore, even when the electric charges flow into the capacitors in the periphery columns of $Y_1$ and $Y_n$, the states of the capacitors in the periphery columns of $Y_1$ and $Y_n$ are hard to be affected.

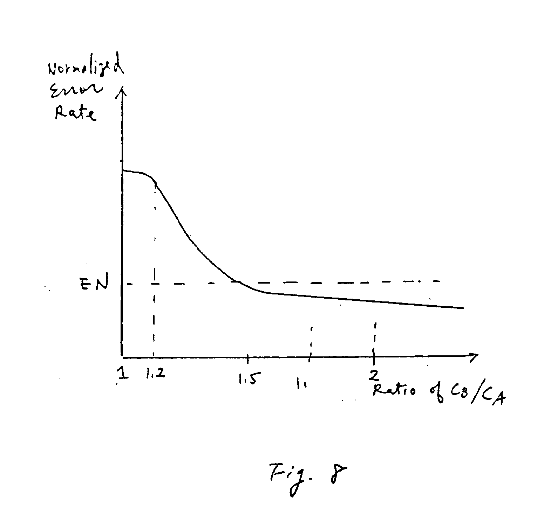

Referring to Fig. 7, the side part of the memory array according to a second embodiment will be explained.

This embodiment is featured in that the enlarged N-type regions $11''$ have a symmetrical pattern with respect to the respective bit lines DL and $\overline{DL}$ of the periphery columns of $Y_1$ and $Y_n$. Namely, the pitch of the pair of bit lines DL and $\overline{DL}$ of the periphery columns $(Y_1, Y_n)$ is set the same as that of the pair of bit lines DL and $\overline{DL}$ in the inner columns $Y_2$ - $Y_{n-1}$, and only one half width $W_C$ of the regions $11''$, which are outside the pair of bit lines DL and $\overline{DL}$ in the periphery columns of $Y_1$ and $Y_n$ is enlarged. This embodiment is advantageous in keeping the pitch of the pair of bit lines DL and $\overline{DL}$ throughout the memory array.

As has been explained, the present invention effectively reduces the affect of electric charges or noise to the memory array and can provide the improved semiconductor memory device operable stably.

## Claims

1. A semiconductor memory device comprising at least one memory array (10-i) having a plurality of memory cells (MC) arranged in rows and columns, each of said memory cells (MC) including a storage capacitor (CM) and a field effect transistor (QM), **characterized** in that the storage capacitors of the memory cells in the inner columns (Y2,...,Yn-1) other than two outer columns (Y1, Yn) along the both peripheries of said array in columns have a first capacitance and the storage capacitors of the memory cells in said two outer columns (Y1, Yn) have a second capacitance larger than said first capacitance.

2. The semiconductor memory device according to claim 1, **characterized** in that a ratio of said second capacitance to said first capacitance is within a range of 1.2 to 2.

3. The semiconductor memory device according to claim 1, **characterized** in that a plurality of word lines (WL) are arranged in said rows and a plurality of bit lines (DL, $\overline{DL}$) are arranged in said columns in said memory array.

4. The semiconductor memory device according to claim 1, **characterized** in that said second capacitors have width (WB) larger than that (WA) of said first capacitors in direction of said rows.

## Revendications

1. Dispositif de mémoire à semi-conducteur comprenant au moins une matrice mémoires (10-i) ayant une multitude de cellules mémoires (MC) disposées en rangées et colonnes, chacune des cellules mémoires (MC) comportant un condensateur de stockage (CM) et un transistor à effet de champ (QM), caractérisé en ce que les condensateurs de stockage des cellules mémoires dans les colonnes intérieures (Y2 à Yn-1) autres que les deux colonnes extérieures (Y1, Yn) suivant les deux côtés de ladite matrice en colonne ont une première capacité et les condensateurs de stockage des cellules mémoires dans les deux colonnes extérieures (Y1, Yn) ont une seconde capacité plus grande que la première capacité.

2. Dispositif de mémoire à semi-conducteur selon la revendication 1, caractérisé en ce qu'un rapport de la seconde capacité à la première capacité est à l'intérieur d'une plage de 1,2 à 2.

3. Dispositif de mémoire à semi-conducteur selon la revendication 1, caractérisé en ce qu'une multitude de lignes de mots (WL) sont disposées dans les rangées et une multitude de lignes de bits (DL, $\overline{DL}$) sont disposées dans les colonnes de la matrice mémoires.

4. Dispositif de mémoire à semi-conducteur selon la revendication 1, caractérisé en ce que les seconds condensateurs présentent une largeur (WB) supérieure à la largeur (WA) des premiers condensateurs dans la direction des rangées.

## Patentansprüche

1. Halbleiter-Speichereinrichtung mit wenigstens einem Speicherfeld (10-i) mit einer Vielzahl von Speicherzellen (MC), die in Reihen und Spalten angeordnet sind, wobei jede der Speicherzellen (MC) einen Speicherkondensator (CM) und einen Feldeffekttransistor (QM) enthält, dadurch **gekennzeichnet,** daß die Speicherkondensatoren der Speicherzellen in den innenliegenden Spalten (Y2-Yn-1) anders als die in den Zwei außenliegenden Spalten (Y1, Yn) entlang beider Außenseiten des Spaltenfeldes eine erste Kapazitanz haben und die Speicherkondensatoren der Speicherzellen in den zwei außenliegenden Spalten (Y1, Yn) eine zweite Kapazitanz haben, die größer als die erste Kapazitanz ist.

2. Halbleiter-Speichereinrichtung nach Anspruch 1, dadurch **gekennzeichnet,** daß das Verhältnis der zweiten Kapazitanz zur ersten Kapazitanz im Bereich von 1,2 bis 2 liegt.

3. Halbleiter-Speichereinrichtung nach Anspruch 1, dadurch **gekennzeichnet,** daß eine Vielzahl von Wortleitungen (WL) in den Reihen und eine Vielzahl von Bit-Leitungen (DL, DL') in den Spalten des Speicherfeldes angeordnet sind.

4. Halbleiter-Speichereinrichtung nach Anspruch 1, dadurch **gekennzeichnet,** daß die zweiten Kondensatoren in Richtung der Reihen eine Breite (WB) haben, die größer als die Breite (WA) der ersten Kondensatoren ist.

Fig. 1

Fig. 2

6

DL (D̄L̄)

WL

Q$_M$

C$_M$

MC

Fig. 3

D̄L̄

11

WL

WL

11

6

7

8

DL

wL

11

wL

6

8

7

9

Y$_1$

Y$_2$

Fig. 4     Prior Art

Fig. 5

Fig. 6

Fig. 7

Fig. 8